(19)

Europäisches
Patentamt
European
Patent Office
Office européen
des brevets

(11) **EP 2 200 093 A1**

(12) **EUROPEAN PATENT APPLICATION**
published in accordance with Art. 153(4) EPC

(43) Date of publication:
**23.06.2010 Bulletin 2010/25**

(51) Int Cl.:
***H01L 31/042*** (2006.01)

(21) Application number: **08833923.9**

(22) Date of filing: **25.09.2008**

(86) International application number:
**PCT/JP2008/067305**

(87) International publication number:
**WO 2009/041506 (02.04.2009 Gazette 2009/14)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **26.09.2007 JP 2007249065**

(71) Applicant: **Hitachi Chemical Company, Ltd.
Tokyo 163-0449 (JP)**

(72) Inventors:
• **FUKUSHIMA, Naoki
Chikusei-shi
Ibaraki 308-8524 (JP)**
• **TSUKAGOSHI, Isao
Tokyo 108-0023 (JP)**

(74) Representative: **HOFFMANN EITLE
Patent- und Rechtsanwälte
Arabellastrasse 4
81925 München (DE)**

(54) **MEMBER FOR CONDUCTOR CONNECTION, METHOD FOR MANUFACTURING THE SAME, CONNECTION STRUCTURE, AND SOLAR CELL MODULE**

(57)     The member for conductor connection of the invention is a member for conductor connection having an adhesive layer 3 formed on at least one side of a metal foil 1, wherein the metal foil 1 comprises a plurality of projections 2 of substantially equal height integrated with the metal foil 1, on the side on which the adhesive layer 3 is formed, and the adhesive layer 3 is formed to a substantially uniform thickness along the projections 2.

*Fig.1*

EP 2 200 093 A1

**Description**

**Technical Field**

The present invention relates to a member for conductor connection and a method for manufacturing it, a connection structure and a solar cell module, and particularly it relates to a member for conductor connection that is suitable for connection between solar cells with electrodes and a method for manufacturing it, as well as to a connection structure employing the member for conductor connection, and a solar battery. The member for conductor connection of the invention also has a wide range of applications for electrical connection of electrodes that are separated at two points, such as in electromagnetic wave shields and short mode uses.

**Background Art**

Solar cell modules have a construction wherein a plurality of solar cells are connected in series and/or in parallel via wiring members that are electrically connected to their surface electrodes. Solder has traditionally been used for connection between electrodes and wiring members (see Patent document 1, for example). Solder is widely used because of its excellent connection reliability, including conductivity and anchoring strength, low cost and general applicability.

Wiring connection methods that do not employ solder have been investigated, as well, from the viewpoint of environmental protection. For example, Patent documents 2 and 3 disclose connection methods employing paste-like or film-like conductive adhesives.

[Patent document 1] Japanese Unexamined Patent Publication No. 2004-2flu256
[Patent document 2] Japanese Unexamined Patent Publication No. 2000-286436
[Patent document 3] Japanese Unexamined Patent Publication No. 2005-101519

**Disclosure of the Invention**

Problems to be Solved by the Invention

In the aforementioned connection method employing solder described in Patent document 1, given a solder melting temperature of generally about 230-260°C, the high temperature of connection and the volume shrinkage of the solder adversely affect the solar cell semiconductor structure, tending to impair the characteristics of the fabricated solar cell module. In addition, the recent decreasing thicknesses of semiconductor boards have tended to result in even more cell cracking and warping. Moreover, because solder connection does not allow easy control of the distance between electrodes and wiring members, it has been difficult to obtain satisfactory dimensional precision for packaging. When sufficient dimensional precision cannot be achieved, product yield tends to be reduced during the packaging process.

On the other hand, methods of establishing connection between electrodes and wiring members using conductive adhesives, as described in Patent documents 2 and 3, allow bonding to be achieved at low temperature compared to using solder, thus potentially reducing the adverse effects on solar cells by heating at high temperature. In order to fabricate a solar cell module by this method, however, it is necessary to repeat a step of first applying or laminating a paste-like or film-like conductive adhesive on a solar cell electrode to form an adhesive layer and then positioning and subsequently bonding a wiring member on the formed adhesive layer, for each electrode. The connection step is therefore complex, resulting in reduced productivity for solar cell modules. The methods described in Patent documents 2 and 3 do not take into account the effect of the surface condition of the adherend, and in some cases it has not been possible to obtain sufficient connection reliability (especially connection reliability with high-temperature, high-humidity).

It is an object of the present invention, which has been accomplished in light of these circumstances, to provide a member for conductor connection which can simplify the connection steps for electrical connection between mutually separate conductors, while also obtaining excellent connection reliability, as well as a method for manufacturing the same. It is a further object of the invention to provide a connection structure and solar cell module whereby excellent productivity and high connection reliability can both be achieved.

Means for Solving the Problems

In order to achieve the objects stated above, the invention provides a member for conductor connection having an adhesive layer formed on at least one side of a metal foil, wherein the metal foil comprises a plurality of projections of substantially equal height integrated with the metal foil, on the side on which the adhesive layer is formed, and the adhesive layer is formed to a substantially uniform thickness along the projections.

The member for conductor connection of the invention has a metal foil serving in place of wiring, and the metal foil is connected and anchored to the conductor as the adherend by the adhesive layer, with the metal foil and adhesive layer being integrated. Using such a member for conductor connection, connection between the electrode of a solar cell, for example, and the metal foil serving as wiring can be very efficiently accomplished in only a single step.

The member for conductor connection of the invention may be used in place of solder for electrical connection between solar cells with excellent connection reliability, while limiting thermal damage to the solar cells. That is, because the member for conductor connection of the invention accomplishes connection between a metal foil and a conductor by an adhesive layer, the connection temperature may be a low temperature of 200°C or below and warping of the board is inhibited, while the thickness of the adhesive layer can also be easily controlled since it is formed in a tape-like manner at a constant thickness.

In addition, since the member for conductor connection of the invention has a plurality of projections of substantially equal height on the metal foil surface, and the adhesive layer is formed to a substantially uniform thickness along the projections, connection is facilitated while avoiding inclusion of air bubbles during connection to conductors, and low-resistance connection can be accomplished for superior connection reliability. The connection manageability is also improved.

Furthermore, since the thickness of the adhesive layer may be set in consideration of the surface condition of the conductor as the adherend and only a single connection step is involved as described above, it is possible to accomplished highly efficient connection.

The member for conductor connection of the invention preferably permits electrical conduction between the metal foil and conductor when it is connected to the conductor by hot pressing.

Also, the projections in the member for conductor connection of the invention have shapes with smaller cross-sectional areas at the tips than the cross-sectional areas at the bases, and are regularly arranged with a center point spacing L between adjacent projections tips in the range of 0.1-5 mm, while the heights H of the projections are preferably less than the center point spacing L. The projections preferably have shapes wherein the cross-sectional areas at the tips are smaller than the cross-sectional areas at the bases, because this will facilitate degassing of air bubbles at the interface between the member for conductor connection and the conductor during connection. Also, if they are regularly arranged so that the center point spacing L between adjacent projections tips is in the range of 0.1-5 mm, formation of the projections will be facilitated and stabilized, while the member will be suitable even for connection with small-area conductors and it will be possible to obtain stable and satisfactory conduction between the metal foil and conductor during connection.

The metal foil used in the member for conductor connection of the invention is preferably one comprising at least one metal selected from the group consisting of Cu, Ag, Au, Fe, Ni, Pb, Zn, Co, Ti, Mg, Sn and Al. This will allow more satisfactory conduction to be obtained between the metal foil and conductor upon connection.

The adhesive layer in the member for conductor connection of the invention is preferably a layer comprising a thermosetting adhesive composition that contains a latent curing agent. This will allow curing of the adhesive layer at low temperature in a short period of time while also providing storage stability, as well as connection manageability and excellent adhesion by the molecular structure.

In addition, the adhesive layer in the member for conductor connection of the invention is preferably a layer comprising an adhesive composition that contains conductive particles, wherein the mean particle size of the conductive particles is no greater than the heights H of the projections of the metal foil. This will allow high levels of both adhesion and conductivity between the metal foil and conductor to be obtained.

The invention further provides a method for manufacturing a member for conductor connection according to the invention, the method comprising a step of forming the projections on at least one side of the metal foil, and then laminating an adhesive film on the side of the metal foil on which the projections have been formed to form an adhesive layer.

The invention further provides a method for manufacturing a member for conductor connection according to the invention, the method comprising a step of forming the adhesive layer on at least one side of the metal foil, and then embossing the metal foil to form projections on the side of the metal foil on which the adhesive layer has been formed.

A member for conductor connection of the invention can be efficiently manufactured by these methods for manufacturing a member for conductor connection.

The invention still further provides a connection structure with the metal foil and conductor electrically connected and bonded, the connection structure being obtained by situating a member for conductor connection according to the invention and a conductor so that the side of the metal foil of the member for conductor connection on which the projections have been formed and the conductor are facing each other via the adhesive layer, and then hot pressing them.

Since a metal foil, as a wiring member, is electrically connected to the conductor by a member for conductor connection of the invention in the connection structure of the invention, the connection steps can be simplified and excellent connection reliability can be obtained. Such a connection structure according to the invention may be applied to electrical and electronic parts requiring wiring connection (especially solar cell modules), to improve part productivity and enhance connection reliability.

In the connection structure of the invention, the surface of the conductor connected to the metal foil preferably has surface roughness, and the projections on the surface roughness sections of the conductor are preferably in contact with the projections of the metal foil. This will increase the number of contact points between the metal foil and conductor, thus allowing a connection structure with lower resistance and higher connection reliability to be obtained.

In the connection structure of the invention, preferably the adhesive layer comprises conductive particles and the conductor and metal foil are electrically connected via the conductive particles. This will increase the number of contact points between the metal foil and conductor, thus allowing a connection structure with lower resistance and higher connection reliability to be obtained.

The invention further provides a solar cell module comprising a plurality of solar cells with surface electrodes, wherein each of the solar cells is electrically connected to the surface electrode via a metal foil bonded with a bonding member, and the metal foil is formed of a member for conductor connection according to the invention described above, where the side of the metal foil in contact with the surface electrode is the side on which the projections have been formed.

Since each of the solar cells is connected together via the metal foil formed of a member for conductor connection according to the invention in the solar cell module of the invention, production is facilitated and excellent connection reliability can be obtained. With the solar cell module of the invention, therefore, it is possible to obtain both excellent productivity and high connection reliability.

In the solar cell module of the invention, preferably the bonding member comprises conductive particles, with the surface electrode and metal foil being electrically connected via the conductive particles. This will increase the number of contact points between the metal foil and the surface electrode, thus allowing a solar cell module with lower resistance and higher connection reliability to be obtained.

In the solar cell module of the invention, preferably the surface of the surface electrode on which the metal foil is to be connected has surface roughness, and the projections on the surface roughness sections of the surface electrode are in contact with the projections of the metal foil to form electrically connected sections, while the sections of the metal foil other than those at the electrically connected sections are essentially covered by the bonding member. This will increase the number of contact points between the metal foil and the surface electrode, thus allowing a solar cell module with lower resistance and higher connection reliability to be obtained.

**Effect of the Invention**

Thus, according to the invention it is possible to provide a member for conductor connection that can simplify the connection steps for electrical connection between mutually separate conductors while also obtaining excellent connection reliability, as well as a method for manufacturing the same. According to the invention it is also possible to provide a connection structure and solar cell module whereby excellent productivity and high connection reliability can both be achieved.

**Brief Description of the Drawings**

Fig. 1 is a schematic cross-sectional view showing an embodiment of a member for conductor connection according to the invention.
Fig. 2 is a schematic cross-sectional view showing another embodiment of a member for conductor connection according to the invention.
Fig. 3 is a schematic cross-sectional view showing another embodiment of a member for conductor connection according to the invention.
Fig. 4 is a schematic cross-sectional view showing another embodiment of a member for conductor connection according to the invention.
Fig. 5 is a schematic view showing an example of an arrangement of projections according to the invention.
Fig. 6 is a schematic view showing another example of an arrangement of projections according to the invention.
Fig. 7 is a schematic view showing another example of an arrangement of projections according to the invention.
Fig. 8 is a cross-sectional schematic view showing a connection structure wherein a member for conductor connection according to an embodiment is connected to a conductor.
Fig. 9 is a cross-sectional schematic view showing a connection structure wherein a member for conductor connection according to the invention is connected to a conductor.
Fig. 10 is a cross-sectional schematic view showing a connection structure wherein a member for conductor connection according to the invention is connected to a conductor.

Fig. 11 is a schematic view of the essential portion of a solar cell module according to the invention.
Fig. 12 is a schematic cross-sectional view of part of a solar cell module according to the invention.

Explanation of Symbols

1: Metal foil, 2: projections, 3: adhesive layer, 3a: cured product, 4: conductor, 5: conductive particles, 6: void (adhesive unfilled section), 10, 20, 30, 40: members for conductor connection, 10a: wiring member, 11: semiconductor wafer, 12: grid electrode, 13: rear electrode, 14a: bus electrode (surface electrode), 14b: bus electrode (surface electrode), 100: solar cell module.

**Best Mode for Carrying Out the Invention**

Preferred embodiments of the invention will now be explained in detail, with reference to the accompanying drawings. Identical or corresponding parts in the drawings will be referred to by like reference numerals and will be explained only once. Unless otherwise specified, the vertical and horizontal positional relationships are based on the positional relationships in the drawings. Also, the dimensional proportions depicted in the drawings are not necessarily limitative.

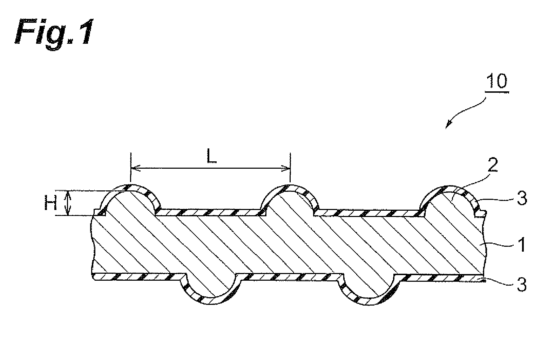

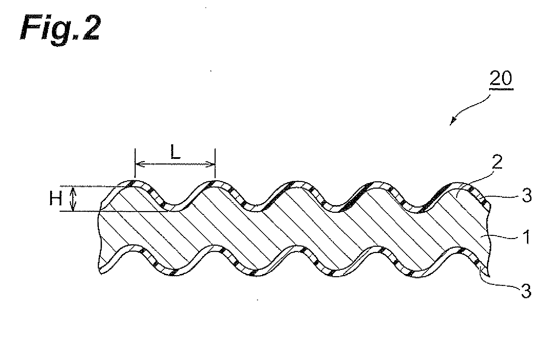

Figs. 1 and 2 are schematic cross-sectional views showing embodiments of members for conductor connection according to the invention. The member for conductor connection 10 in Fig. 1 and the member for conductor connection 20 shown in Fig. 2 each comprise a metal foil 1 having projections 2 on both main sides, and adhesive layers 3 formed on both main sides of the metal foil 1, and they have the form of an adhesive-attached metal foil tape. The projections 2 are integrated with the metal foil 1, and they have shapes with substantially equal heights. The adhesive layer 3 is formed to a substantially uniform thickness along the projections 2.

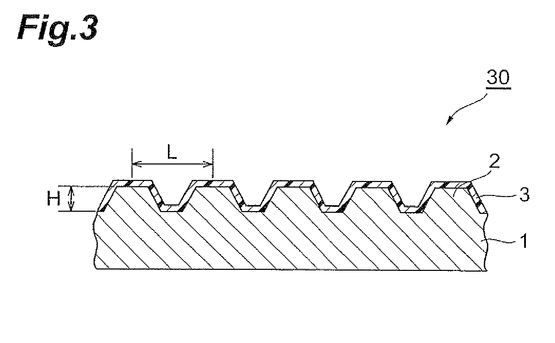

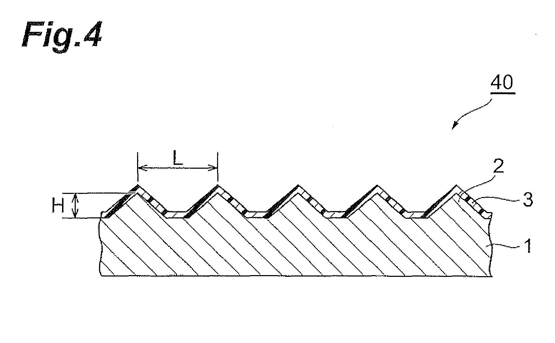

Figs. 3 and 4 are schematic cross-sectional views showing other embodiments of the members for conductor connection according to the invention. The member for conductor connection 30 shown in Fig. 3 and the member for conductor connection 40 shown in Fig. 4 each comprise a metal foil 1 having projections 2 on one main side, with an adhesive layer 3 formed on the main side of the metal foil 1 on which the projections 2 are formed, and they also have the form of an adhesive-attached metal foil tape. The projections 2 are integrated with the metal foil 1, and they have shapes with substantially equal heights. The adhesive layer 3 is formed to a substantially uniform thickness along the projections 2.

When a member for conductor connection having the projections 2 and adhesive layers 3 formed on both sides of the metal foil 1 as shown in Fig. 1 and Fig. 2 is used to fabricate a solar cell module as described hereunder, it is easy to carry out the connecting step for connection between the solar cell surface electrode and the surface electrode (rear electrode) formed on the back side of the adjacent solar cell. That is, since adhesive layers 3 are provided on both sides, connection can be established between the surface electrode and rear electrode without reversing the member for conductor connection.

On the other hand, the members for conductor connection having the projections 2 and adhesive layer 3 formed on only one side of the metal foil 1 as shown in Fig. 3 and Fig. 4 facilitate formation of the projections 2 and adhesive layer 3 and are superior in terms of cost, and consequently they are also suitable for connection between conductors formed on the same surface.

The members for conductor connection 10, 20, 30, 40 are in the form of adhesive-attached metal foil tapes, and for winding up into a tape, it is preferred either to provide a separator such as a release sheet on the adhesive layer 3 side or, in the case of the members for conductor connection 30 and 40, to provide a back side treatment layer of silicon or the like on the back side of the metal foil 1.

The projections 2 preferably have shapes wherein the cross-sectional areas at the tips are smaller than the cross-sectional areas at the bases, because this will facilitate degassing of air bubbles at the interface between the connecting member and the conductor during connection. The cross-sectional area referred to here is the cross-sectional area measured upon cutting a projection 2 in the plane perpendicular to the thickness direction of the metal foil 1. As shown in Figs. 1-4, the projections 2 most preferably have shapes wherein the cross-sectional area decreases from the base toward the tip (a tapered shape).

The projections 2 also are preferably regularly arranged so that the center point spacing L between adjacent projection tips is in the range of 0.1-5 mm. A smaller center point spacing L within this range will be more suited for connection to small-area adherends, while a larger spacing within this range will be more suited when the production step for the projections 2 involves mechanical treatment, and therefore the value may be selected as appropriate for each case. From the same viewpoint, the center point spacing L is more preferably 0.2-3 mm and especially 0.3-2 mm. The center point spacing L is the center point spacing at the tips between any projection 2 and the projection 2 closest to it. However, the center point spacings between all adjacent projections 2 do not necessarily need to be equal, and they may vary within the aforementioned range.

The heights H of the projections 2 may be set as desired, but a range of about 20-5000 μm is practical. As shown in Figs. 1-4, the heights H of the projections 2 are the heights from the bases to the tips of the projections 2, and they are preferably values that do not exceed the center point spacing L between adjacent projection tips. This will facilitate formation of the projections 2 and production of the connecting member, while also resulting in easier degassing and satisfactory workability during connection. In addition to the projections 2 of substantially equal height, the metal foil 1 may also have projections or irregularities with lower heights than the projections 2.

According to the invention, the heights H and center point spacings L of the projections 2 may be measured using an ordinary caliper or micrometer, but preferably they are determined by observation of the cross-sections of the projections 2 with a metallurgical microscope or electron microscope.

The metal foil 1 "having projections 2 of substantially equal height" according to the invention means that the metal foil 1 has a plurality of projections whose heights have been intentionally adjusted. From the viewpoint of dimensional precision during formation of the projections 2, the heights of the projections 2 may be completely identical, or the heights of the projections 2 may have a range of error of within ±20% and preferably within ±15%. According to the invention, the adhesive layer 3 "being formed to a substantially uniform thickness" means that the adhesive layer 3 is formed with an intentionally adjusted thickness on the metal foil 1. From the viewpoint of dimensional precision during formation of the adhesive layer 3, the thickness of the adhesive layer 3 may be completely uniform, or the thickness of the adhesive layer 3 may have a range of error of within ±20% and preferably within ± 15%.

There are no particular restrictions on the method of forming the projections 2 on the metal foil 1, and common methods may be employed including physical methods with an abrasive powder of controlled particle size or with a roll, and chemical methods such as plating or etching. According to the invention, a method of embossing by rolling the metal foil with a roll having irregularities formed on the surface is preferred to allow easier formation of the projections 2 of substantially equal height in a regular pattern, while also allowing continuous production of the metal foil 1 for excellent productivity.

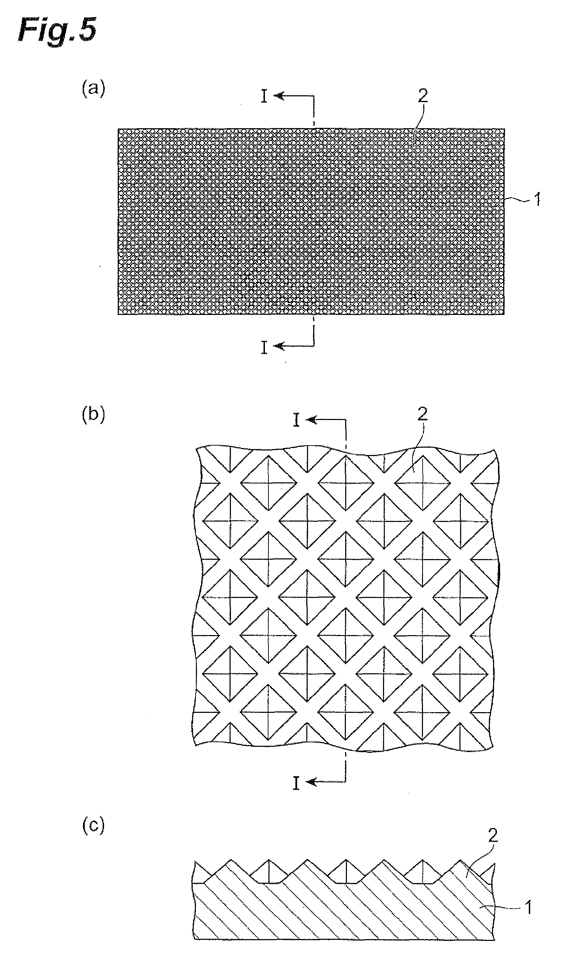

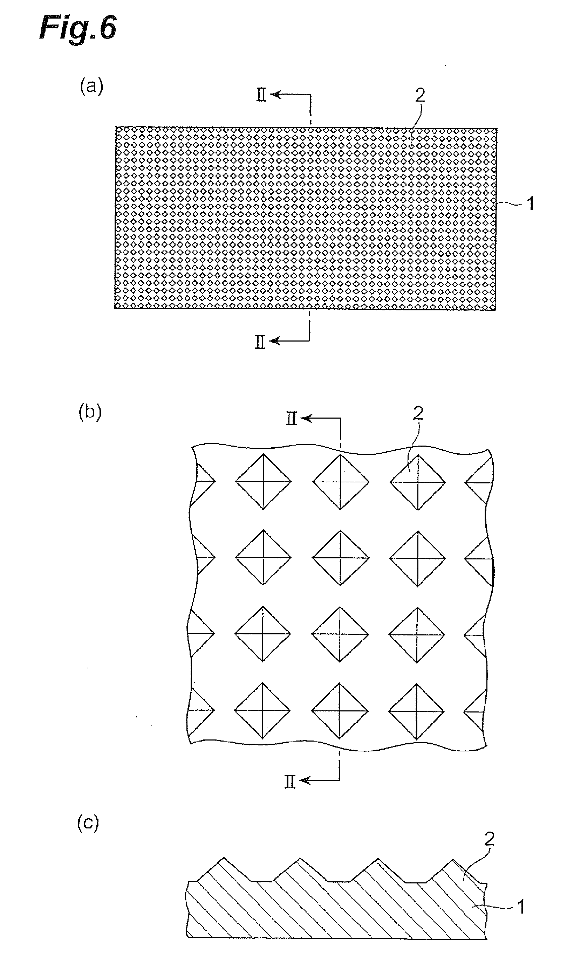

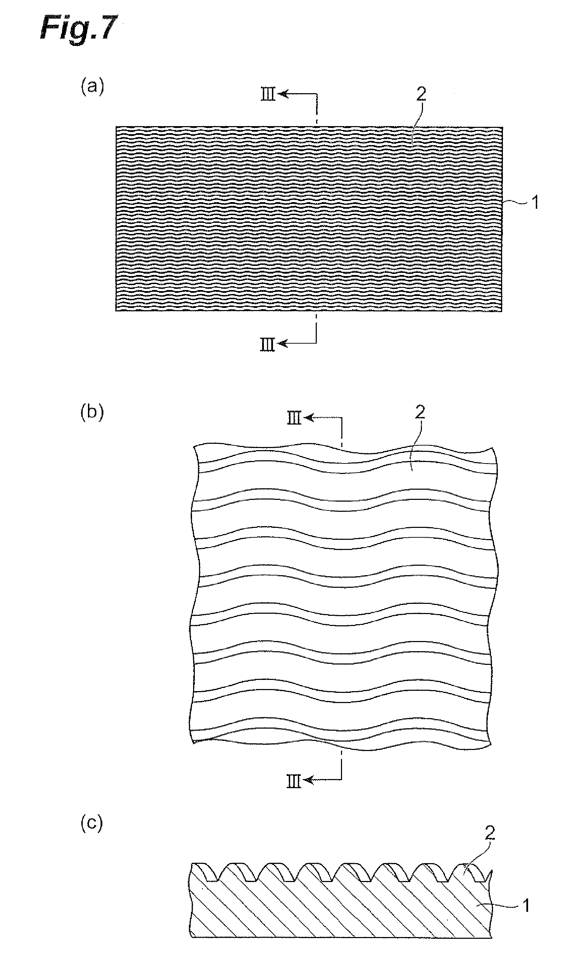

The arrangement pattern of the projections 2 will now be explained with reference to Figs. 5-7. Fig. 5(a) is a plan view schematically showing an example of a projection arrangement, Fig. 5(b) is a partial magnified view of Fig. 5(a), and Fig. 5(c) is a partial cross-sectional view along line I-I of Fig. 5(a). Fig. 6(a) is a plan view schematically showing another example of a projection arrangement, Fig. 6(b) is a partial magnified view of Fig. 6(a), and Fig. 6(c) is a partial cross-sectional view along line II-II of Fig. 6(a). Fig. 7(a) is a plan view schematically showing yet another example of a projection arrangement, Fig. 7(b) is a partial magnified view of Fig. 7(a), and Fig. 7(c) is a partial cross-sectional view along line III-III of Fig. 7(a).

The projections 2 may be independently formed at the vertices of a lattice as shown in Figs. 5 and 6, or they may be continuously formed in undulating fashion as shown in Fig. 7, or linear fashion (not shown). Independent projection will promote conductivity because of the numerous contact points with the adherend during connection, while continuous projection will facilitate degassing from the interface with the adherend during connection, thus helping to prevent inclusion of air bubbles at the joints.

The two-dimensional shapes of the projections 2 may be circular, ellipsoid, or polygonal such as square, rectangular, triangular, quadrilateral, pentagonal or more. Circles, ellipsoids and polygons with minimal acute angles are preferred among these from the viewpoint of facilitating production and obtaining excellent degassing properties during connection. On the other hand, acute angles are preferred for penetration of the adhesive layer 3 by the tips of the projections during connection to allow easier contact with the adherend, and for easier low-resistance connection.

When the projections 2 are present on both main sides of the metal foil 1, the shapes and arrangement patterns of the projections 2 on both main sides may be the same or different.

From the viewpoint of conductivity, corrosion resistance and flexibility, the metal foil 1 used may be one comprising at least one metal selected from the group consisting of Cu, Ag, Au, Fe, Ni, Pb, Zn, Co, Ti, Mg, Sn and Al, or a lamination of the foregoing. Copper and aluminum foils which have excellent conductivity are preferred among these.

The thickness of the metal foil 1 is preferably 5-150 μm.
When the member for conductor connection is wound up as a tape, the thickness of the metal foil 1 is preferably 20-100 μm from the viewpoint of deformability and manageability. When the metal foil 1 has a small thickness and lacks strength, it may be reinforced with a plastic film or the like. The thickness of the metal foil 1 is the minimum thickness excluding the heights of the projections 2.

Particularly preferred of the metal foils 1 described above are rolled copper foils used in copper-clad laminates that serve as printed circuit board materials, because they are flexible and they permit easier mechanical working such as embossing, while they are also available as general purpose materials and economical.

The adhesive layer 3 may be a widely used material formed from an adhesive composition comprising a thermoplastic material or a curable material that exhibits curable properties under heat or light. The adhesive layer 3 for this embodiment preferably contains a curable material from the viewpoint of excellent heat resistance and humidity resistance after connection. Thermosetting resins may be mentioned as curable materials, and any publicly known ones may be used. As examples of thermosetting resins there may be mentioned epoxy resins, phenoxy resins, acrylic resins, phenol resins, melamine resins, polyurethane resins, polyester resins, polyimide resins and polyamide resins. From the standpoint of connection reliability, the adhesive layer 3 preferably contains at least one from among epoxy resins, phenoxy resins and acrylic resins.

The adhesive layer 3 preferably comprises a thermosetting resin and a latent curing agent for the thermosetting resin. A latent curing agent has relatively distinct activation points for reaction initiation by heat and/or pressure, and is suitable for connection methods that involve hot pressing steps. The adhesive layer 3 more preferably contains an epoxy resin and a latent curing agent for the epoxy resin. An adhesive layer 3 formed from an epoxy-based adhesive containing a latent curing agent can be cured in a short period of time, has good workability for connection and exhibits excellent adhesion by its molecular structure.

As epoxy resins there may be mentioned bisphenol A-type epoxy resin, bisphenol F-type epoxy resin, bisphenol S-type epoxy resin, phenol-novolac-type epoxy resin, cresol-novolac-type epoxy resin, bisphenol A/novolac-type epoxy resin, bisphenol F/novolac-type epoxy resin, alicyclic epoxy resin, glycidyl ester-type epoxy resin, glycidyl atnine-type epoxy resin, hydantoin-type epoxy resin, isocyanurate-type epoxy resin, aliphatic chain epoxy resins and the like. These epoxy resins may be halogenated or hydrogenated. These epoxy resins may also be used in combinations of two or more.

As latent curing agents there may be mentioned anionic polymerizable catalyst-type curing agents, cationic polymerizable catalyst-type curing agents and polyaddition-type curing agents. Any of these may be used alone or in mixtures of two or more. Preferred among these are anionic and cationic polymerizable catalyst-type curing agents since they have excellent fast-curing properties and do not require special consideration in regard to chemical equivalents.

As examples of anionic or cationic polymerizable catalyst-type curing agents there may be mentioned tertiary amines, imidazoles, hydrazide-based compounds, boron trifluoride-amine complexes, onium salts (sulfonium salts, ammonium salts, etc.), amineimides, diaminomaleonitrile, melamine and its derivatives, polyamine salts, and dicyandiamides, and modified forms of the foregoing may also be used. As polyaddition-type curing agents there may be mentioned polyamines, polymercaptanes, polyphenols, acid anhydrides and the like.

When a tertiary amine or imidazole is used as an anionic polymerizable catalyst-type curing agent, the epoxy resin is cured by heating at a moderate temperature of about 160°C-200°C for between several tens of seconds and several hours. This is preferred because it lengthens the pot life.

As cationic polymerizable catalyst-type curing agents there are preferred photosensitive onium salts that cure epoxy resins under energy ray exposure (mainly aromatic diazonium salts, aromatic sulfonium salts and the like). Aliphatic sulfonium salts are among those that are activated and cure epoxy resins by heat instead of energy ray exposure. Such curing agents are preferred because of their fast-curing properties.

Microencapsulated forms obtained by covering these curing agents with polyurethane-based or polyester-based polymer substances; or inorganic materials such as metal thin-films of nickel or copper, or calcium silicate, are preferred as they can extend the pot life.

The activation temperature of the adhesive layer 3 is preferably 40-200°C. If the activation temperature is below 40°C, the temperature difference against room temperature (25°C) will be smaller and a low temperature will be required for storage of the connecting member, while if it is above 200°C there will tend to be thermal effects on members other than those at the joints. From the same viewpoint, the activation temperature of the adhesive layer 3 is more preferably 50-150°C. The activation temperature of the adhesive layer 3 is the exothermic peak temperature upon temperature increase of the adhesive layer 3, as the sample, from room temperature at 10°C/min using a DSC (differential scanning calorimeter).

Setting a lower activation temperature of the adhesive layer 3 will tend to improve the reactivity but lower the storage life, and therefore it is preferably selected from both these considerations. That is, the member for conductor connection of this embodiment allows temporary connections to be made on conductors formed on boards, and allows metal foils and adhesive-attached boards to be obtained, by heat treatment at the activation temperature of the adhesive layer 3. Furthermore, setting the activation temperature of the adhesive layer 3 within the range specified above can ensure an adequate storage life of the adhesive layer 3 while facilitating highly reliable connection upon heating at above the activation temperature. This allows more effective two-stage curing wherein temporarily connected articles are collectively cured together afterwards. When such temporarily connected articles are produced, there is virtually no viscosity increase in the adhesive layer 3 as curing reaction proceeds at below the activation temperature, and therefore the microirregularities in the electrodes are filled well and production can be more easily managed.

While addition of conductive particles is not absolutely necessary to obtain conductivity in the thickness direction utilizing the irregularities on the surfaces of the projections formed on the metal foil 1 surface of the member for conductor connection of this embodiment, the adhesive layer 3 preferably contains conductive particles from the viewpoint of increasing the number of irregular surfaces during connection to increase the number of contact points.

There are no particular restrictions on the conductive particles, and for example, gold particles, silver particles, copper particles, nickel particles, gold-plated nickel particles, gold/nickel plated plastic particles, copper-plated particles and nickel-plated particles may be mentioned. The conductive particles preferably have burr-shaped or spherical particle shapes from the viewpoint of the filling properties of the conductive particles into the adherend surface irregularities during connection. Specifically, conductive particles in such a form have higher filling properties for complex irregular shapes on metal foil and adherend surfaces, as well as high shape-following properties for variation caused by vibration or expansion after connection, and can therefore improve the connection reliability.

The conductive particles used for this embodiment have a particle size distribution in the range of about 1-50 μm, and preferably 1-30 μm.

The content of conductive particles in the adhesive layer 3 may be within a range that does not notably lower the adhesion of the adhesive layer 3, and for example, it may be up to 10 vol% and preferably 0.1-7 vol% based on the total volume of the adhesive layer 3.

When the adhesive layer 3 of the member for conductor connection of this embodiment contains conductive particles, the mean particle size D (μm) of the conductive particles is preferably equal to or smaller than the heights H of the projections 2, from the viewpoint of achieving a high level for both the adhesion and conductivity. This embodiment is characterized by allowing a wide range to be selected for the particle size distribution, because the conductive particles can easily follow the projections 2 of the metal foil 1 or roughness on the adherend.

When the adhesive layer 3 of the member for conductor connection of this embodiment comprises a latent curing agent, the mean particle size of the latent curing agent is preferably equal to or smaller than the heights H of the projections 2 or the mean particle size D of the conductive particles. By limiting the mean particle size of the latent curing agent to no greater than the heights of the projections 2 on the metal foil 1 or the mean particle size D of the conductive particles, as the stable materials that are generally harder than the latent curing agent, it is possible to prevent loss of the latent curing agent function when the member for conductor connection has been subjected to pressure during storage, and to improve the adhesion while adequately maintaining the storage stability of the member for conductor connection. These conditions are particularly effective for guaranteeing the storage stability when the member for conductor connection is a wound-up tape.

Throughout the present specification, the mean particle size D of the conductive particles is the value determined by the following formula. The mean particle size of the latent curing agent is the value determined in the same manner.

[Equation 1]

$$D = \sum nd / \sum n$$

Here, n represents the number of particles with maximum diameter d. The method of measuring the particle size may be an electron microscope, optical microscope, Coulter counter or light scattering method, all of which are commonly employed. When the particles have an aspect ratio, d is the center diameter. According to the invention, measurement is preferably conducted on at least 10 particles using an electron microscope.

The adhesive layer 3 may also contain, in addition to the components mentioned above, modifying materials such as silane-based coupling agents, titanate-based coupling agents or aluminate-based coupling agents in order to improve the adhesion or wettability between the curing agent, curing accelerator and substrate, dispersing agents such as calcium phosphate or calcium carbonate in order to improve the dispersibility of the conductive particles, and chelate materials to prevent silver or copper migration.

The member for conductor connection of the embodiment described above may be placed on the conductor and hot pressed to bond the metal foil and conductor while obtaining electrical conduction between the metal foil and conductor during electrification.

The member for conductor connection of this embodiment is suitable as a connecting member for connection between multiple solar cells in series and/or parallel.

A method for manufacturing the member for conductor connection of this embodiment will now be described. The conductive connecting member may be one of two types, wherein either the projections 2 are formed on the metal foil 1 before forming the adhesive layer 3, or after forming it.

As the former method, there may be mentioned a method in which the projections 2 are formed by embossing, for example, and then an adhesive film is laminated onto the side of the metal foil 1 on which the projections 2 have been formed, to form the adhesive layer. This method is particularly preferred because it improves production workability during formation of the adhesive layer 3 on both sides of the metal foil 1, and also allows projections 2 to be prepared on the surface of the metal foil 1 beforehand under constant conditions, thereby greatly aiding mass production. In this method, the projections 2 may also be formed by processes other than embossing. The process for formation of the projections 2 may be a physical or chemical process, as mentioned above.

As the latter method there may be mentioned a method in which the projections 2 are formed on the metal foil by embossing the metal foil and adhesive layer after the smooth metal foil has been covered with the adhesive layer. This method is particularly suitable for forming an adhesive layer 3 on one side of the metal foil 1, and it is preferred since it can reliably prevent inclusion of contaminants such as dust in the interface between the metal foil 1 and adhesive layer 3.

A conductor connection structure employing a member for conductor connection according to this embodiment will now be described.

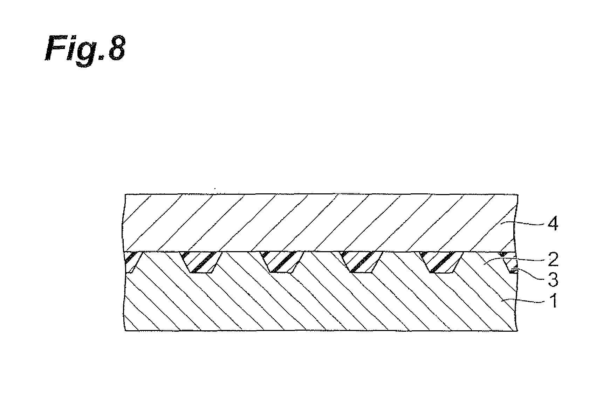

Figs. 8 to 10 are cross-sectional schematic views showing connection structures wherein a member for conductor connection according to this embodiment is connected to a conductor. As seen in Figs. 8 to 10, the projections 2 of the member for conductor connection in the connection structure of this embodiment are directly contacted with a conductive adherend (conductor) 4 mainly by hot pressing during connection, to establish conduction between the metal foil 1 and conductor 4. That is, the connection structure of this embodiment is a connection structure wherein the projections 2 on the surface of the metal foil 1 of the member for conductor connection are in contact with the conductor 4, and anchored by the adhesive layer 3. The conductivity obtained by contact between the projections 2 and conductor 4 is fixed and maintained by the adhesive force and curing shrinkage force of the adhesive layer 3.

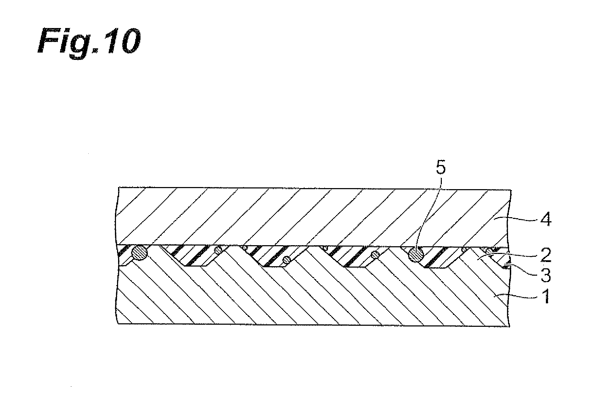

In the connection structure shown in Fig. 10, the adhesive layer 3 comprises conductive particles 5. In this case, the projections 2 and conductor 4 are in direct contact for conduction between the metal foil 1 and conductor 4, while the conductive particles 5 are also present at some sections between the projections 2 and conductor 4, and conduction also takes place between the metal foil 1 and conductor 4 via the conductive particles 5. Thus, the number of contact points is increased by the conductive particles 5 in addition to the contact points between the projections 2 and conductor 4, thus allowing a connection structure with lower resistance and higher connection reliability to be obtained.

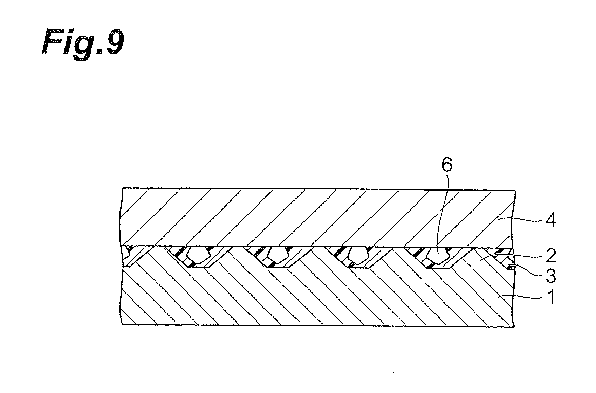

The thickness of the adhesive layer 3 may generally be in a range that allows electrical connection between the metal foil 1 and conductor 4 after connection, and allows that state to be fixed and maintained. Within such a range, the adhesive layer 3 may have void sections 6 with a low amount of adhesive that are unfilled, as shown in Fig. 9. In order to obtain high adhesive force, it is preferred for the amount of adhesive to be a sufficiently filling amount to cover the periphery of the conductor 4 and projections 2 so that no void sections 6 are present, when the member for conductor connection has been connected to the conductor 4 by hot pressing, as shown in Fig. 8 or Fig. 10.

The thickness of the adhesive layer 3 may be appropriately set based on the average height of the center sections of the projections 2, although a greater thickness is preferred form the viewpoint of adhesion and a smaller thickness is preferred from the viewpoint of conductivity, and therefore the thickness may be adjusted in consideration of both of these properties. From the viewpoint of obtaining both satisfactory adhesion and conductivity, the thickness of the adhesive layer 3 is preferably about 5-50 $\mu$m, and more preferably 10-40 $\mu$m from the viewpoint of obtaining high reliability. The thickness of the adhesive layer 3 is also preferably smaller than the thickness of the metal foil 1 for better manageability.

The thicknesses of the adhesive layer 3 and metal foil 1 are measured using a micrometer (trade name: ID-C112C by Mitutoyo Corp.). For measurement of the thickness of the adhesive layer 3, first the entire thickness including the adhesive layer 3 and metal foil 1 is measured, and then the adhesive layer 3 is removed with a solvent or the like for measurement of the thickness of the metal foil 1 alone, and the difference is determined as the thickness of the adhesive layer 3.

In order to obtain electrical conduction between the projections 2 and the conductor 4, the adhesive layer 3 need to be removed from between the projections 2 and conductor 4 either by thrusting of the tips of the projections 2 into or their contact with the conductor 4, or by insulation breakdown under voltage. From this viewpoint as well, it is important to adjust the thickness of the adhesive layer 3. According to member for conductor connection of this embodiment, the metal foil and conductor are satisfactorily bonded by hot pressing while low resistance conduction of no greater than about $10^{-1}$ $\Omega$/cm$^2$ is also achieved between the metal foil and conductor during electrification.

The connection structure of this embodiment preferably also has surface roughness on the surface of the conductor 4 that is connected with the metal foil 1. This will increase the number of contact points between the projections 2 and conductor 4, thus allowing a connection structure with lower resistance and higher connection reliability to be obtained.

A conductor connection method employing a member for conductor connection according to this embodiment will now be described.

The conductor connection method of the first embodiment is a method for electrical connection between a mutually separate first conductor and second conductor using a member for conductor connection comprising the projections 2 and adhesive layer 3 on both sides of the metal foil 1, and it comprises a first step in which part of the member for conductor connection and a first conductor are laid facing each other and are hot pressed for electrical connection and bonding of the metal foil 1 and the first conductor, and a second step in which another part of the member for conductor connection and a second conductor are laid facing each other and are hot pressed for electrical connection and bonding of the metal foil 1 and second conductor. The first conductor and second conductor thus become electrically connected via the metal foil 1 bonded to the conductors. The conductor connection method of this embodiment is suitable for connection of multiple solar cells in series, for example.

The first step and second step may be carried out simultaneously or in the order of first step and second step, or in the reverse order. In the second step, the side of the member for conductor connection that is to be connected with the second conductor may be the same side as the side of the member for conductor connection that is to be connected with the first conductor. This is preferred when, for example, multiple solar cells are connected in parallel.

The conductor connection method of the second embodiment is a method for electrical connection between a mutually separate first conductor and second conductor using a member for conductor connection comprising the projections 2 and adhesive layer 3 on only one side of the metal foil 1, and it comprises a first step in which part of a member for conductor connection and a first conductor are situated with the side of the member for conductor connection having the projections 2 laid facing the first conductor, and these are hot pressed for electrical connection between the metal foil 1 and the first conductor, and a second step in which another part of the member for conductor connection and a second conductor are situated with the side of the member for conductor connection having the projections 2 laid facing the second conductor, and these are hot pressed for electrical connection between the metal foil 1 and the second conductor. The first conductor and second conductor thus become electrically connected via the metal foil 1 bonded to the conductors. The first step and second step may be carried out simultaneously or in the order of first step and second step, or in the reverse order. The conductor connection method of this embodiment is suitable for connection of multiple solar cells in parallel, for example.

As examples of conductors for the conductor connection method of the first embodiment and second embodiment described above, there may be mentioned solar cell bus electrodes, electromagnetic wave shield wiring or ground electrodes, semiconductor electrodes for short modes, or display electrodes.

As known materials that can be used to obtain electrical conduction for solar cell bus electrodes, there may be mentioned ordinary silver-containing glass paste, or silver paste, gold paste, carbon paste, nickel paste or aluminum paste obtained by dispersing conductive particles in adhesive resins, and ITO formed by firing or vapor deposition, but silver-containing glass paste electrodes are preferred from the viewpoint of heat resistance, conductivity, stability and cost. Solar cells generally have an Ag electrode and an Al electrode formed by screen printing or the like, on a semiconductor board composed of at least one selected from Si single-crystal, polycrystal and amorphous materials. The electrode surfaces generally have irregularities of 3-30 $\mu$m. In most cases, the electrodes formed on solar cells are rough, with a ten-point height of roughness profile Rz of 2-18 $\mu$m.

The roughness of an electrode surface is calculated as the ten-point height of roughness profile Rz and the maximum height Ry according to JIS B0601-1994, with observation using an ultradepth three-dimensional profile microscope (trade name: VK-8510) by Keyences, and using imaging/analysis software.

The conditions for the heating temperature and pressing pressure are not particularly restricted so long as they are within a range that can ensure electrical connection between the metal foil 1 and conductor 4 and that allows bonding of the conductor 4 and metal foil 1 by the adhesive layer 3. The pressing and heating conditions are appropriately selected according to the purpose of use, the components in the adhesive layer 3, and the material of the substrate on which the conductor 4 is to be formed. For example, when the adhesive layer 3 contains a thermosetting resin, the heating temperature may be a temperature at which the thermosetting resin cures. The pressing pressure may be in a range that sufficiently bonds the conductor 4 and metal foil 1 and does not damage the conductor 4 or metal foil 1. Also, the heating and pressing time may be a time that does not cause excessive heat transfer to the substrate on which the conductor 4 is formed, to avoid damage to or deterioration of the material. Specifically, the pressing pressure is preferably 0.1 MPa-10 MPa, the heating temperature is preferably 100°C-220°C and the heating/pressing time is preferably no longer than 60 seconds. The conditions are more preferably toward lower pressure, lower temperature and a shorter time.

As explained above, the member for conductor connection of this embodiment is suitable as a connecting member for connection between multiple solar cells in series and/or parallel. The solar battery may be used as a solar cell module comprising a plurality of solar cells connected in series and/or in parallel and sandwiched between tempered glass or the like for environmental resistance, and provided with external terminals wherein the gaps are filled with a transparent resin.

As seen in Figs. 8 to 10, the projections 2 of the member for conductor connection of this embodiment contact with the conductor 4 (cell electrode), or via the conductive particles 5, allowing electrical connection between solar cells.

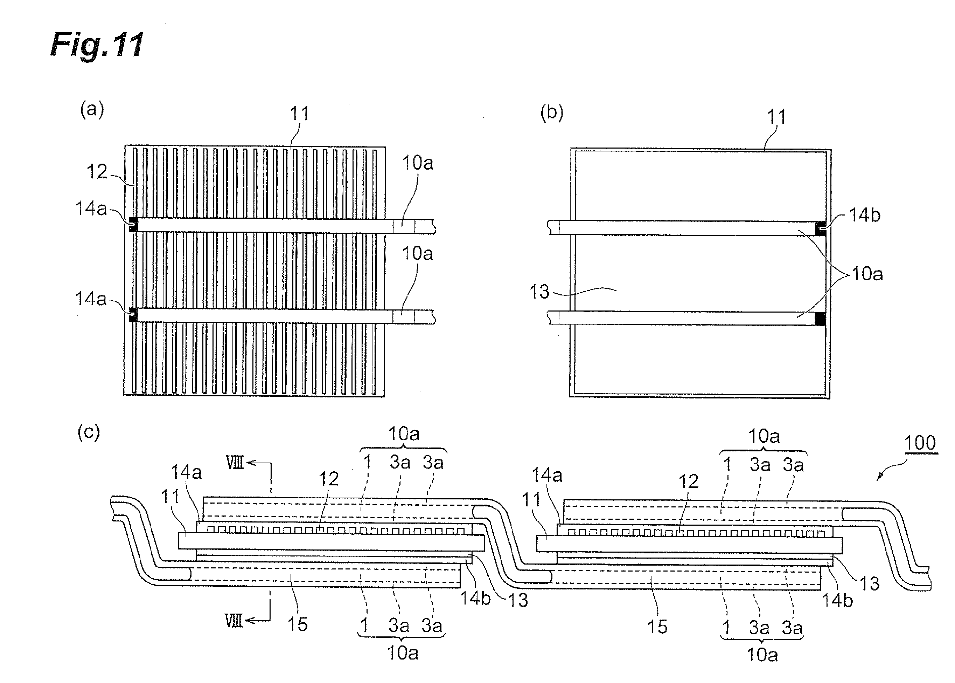

Fig. 11 is a schematic view showing the essential parts of a solar cell module according to this embodiment, as an overview of a structure with reciprocally wire-connected solar cells. Fig. 11(a) shows the front side of the solar cell module, Fig. 11(b) shows the rear side, and Fig. 11(c) shows an edge view.

As shown in Figs. 11(a)-(c), the solar cell module 100 has solar cells, with grid electrodes 12 and bus electrodes (surface electrodes) 14a formed on the front side of a semiconductor wafer 11 and rear electrodes 13 and bus electrodes (surface electrodes) 14b formed on the rear side, the solar cells being reciprocally connected by wiring members 10a. The wiring members 10a each have one end connected to a bus electrode 14a as a surface electrode and the other end connected to a bus electrode 14b as a surface electrode. Each of the wiring members 10a is formed using a conductive connecting member 10. Specifically, one end of the conductive connecting member 10 is placed on the bus electrode 14a facing it, and these are hot pressed in the facing direction, while the other end of the conductive connecting member 10 is placed on the bus electrode 14b facing it and these are also hot pressed in the facing direction, to form the wiring member 10a.

According to this embodiment, the metal foil 1 and bus electrode 14a, and the metal foil 1 and bus electrode 14b, may be connected via conductive particles.

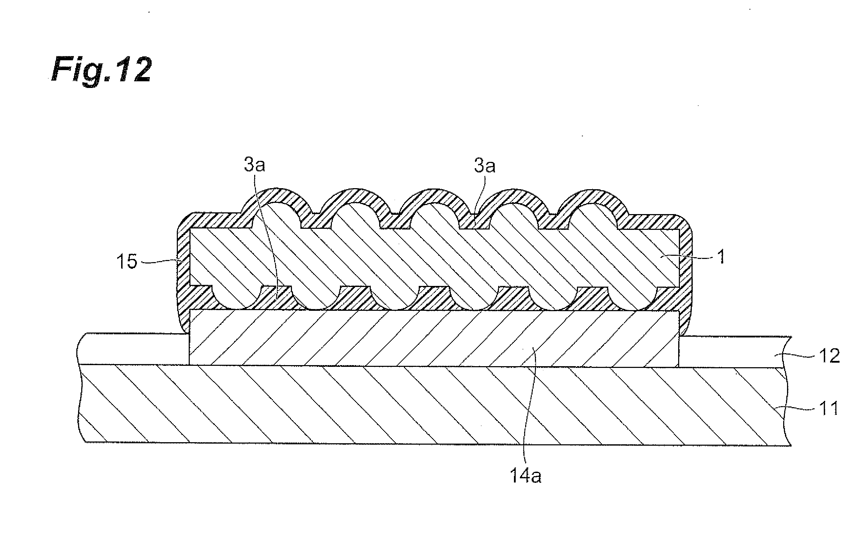

Fig. 12 is a cross-sectional view of the solar cell module shown in Fig. 11(c), along line VIII-VIII. Fig. 12 shows only the front side of the semiconductor wafer 11, omitting the structure of the rear side. The solar cell module of this embodiment is fabricated through a step in which one end of the conductive connecting member 10 is placed on the bus electrode 14a and hot pressed, and it has a structure wherein the metal foil 1 and bus electrode 14a are electrically connected while the metal foil 1 and bus electrode 14a are bonded by the cured product 3a of the adhesive layer 3. Also according to this embodiment, the sections of the metal foil 1 other than the surface in contact with the bus electrode 14a are covered by the cured adhesive (preferably resin). Specifically, the side of the metal foil 1 opposite the side in contact with the bus electrode 14a is covered by the cured product 3a of the adhesive layer 3, and the edges of the metal foil 1 are covered by the cured product 15 of the adhesive (excess adhesive) that has seeped out by hot pressing during connection. In this type of structure, electrical shorts due to contact between the metal foil and other conductive members can be effectively prevented, thus preventing corrosion of the metal foil and improving the durability of the metal foil.

If the conductive connecting member 10 is in the form of a tape as for this embodiment, the width of the member will be extremely small compared to the lengthwise direction and therefore seepage of the adhesive in the direction of the metal foil edges can be increased, thus making it easier to obtain a reinforcing effect on the strength of the joints.

The embodiments described above are preferred embodiments of the invention, but the invention is not limited thereto. The invention may also be applied in a variety of modifications so long as the gist thereof is maintained.

The member for conductor connection of the invention can be applied not only for fabrication of solar battery as described above, but also for fabrication of, for example, short modes of electromagnetic wave shields, tantalum capacitors and the like, aluminum electrolytic capacitors, ceramic capacitors, power transistors, various types of sensors, MEMS-related materials and lead wiring members for display materials.

Examples

The present invention will now be explained in greater detail with reference to examples, with the understanding that the invention is not meant to be limited to these examples.

(Example 1)

(1) Fabrication of adhesive-attached metal foil tape (member for conductor connection)

As a film-forming material, 50 g of a phenoxy resin (trade name: PKHA by Inchem, high molecular weight epoxy resin with molecular weight of 25,000) and 20 g of an epoxy resin (trade name: EPPN, polyfunctional glycidyl ether-type epoxy resin by Nippon Kayaku Co., Ltd.) were dissolved in 175 g of ethyl acetate to obtain a solution. Next, 5 g of a master batch-type curing agent (trade name: NOVACURE by Asahi Kasei Corp., mean particle size: 2 $\mu$m) comprising imidazole-based microcapsules dispersed in a liquid epoxy resin was added to the solution as a latent curing agent, to obtain an adhesive layer-forming coating solution with a solid content of 30 wt%.

The adhesive layer-forming coating solution was coated onto a separator (release-treated polyethylene terephthalate film) and dried at 110°C for 5 minutes to form an adhesive layer. This yielded an adhesive film with an adhesive layer thickness of 30 $\mu$m.

Next, both sides of a rolled copper foil with a thickness of 75 $\mu$m having projections formed on both sides as shown in Table 1 (projections having hemispherical cross-sections as shown in Fig. 1, formed in a continuous undulating fashion as shown in Fig. 7, with a projection base cross-section diameter (short axis diameter) of 500 $\mu$m, a projection height (H) of 0.5 mm and an adjacent projection center point spacing (L) of 1.5 mm), were laminated with the aforementioned adhesive film using a roll coater while heating at 70°C between the rolls to obtain a laminated body. In this example, the projections were formed on the metal foil before forming the adhesive layer, thus allowing the projections to be prepared under constant conditions beforehand. The laminated body had an adhesive layer activation temperature of 120°C.

The laminated body was wound up into a roll while taking up a polyethylene film as a separator on the adhesive layer, to obtain a wound roll. The wound roll was cut to a width of 2.0 mm to obtain an adhesive-attached metal foil tape.

(2) Connection of solar cell using adhesive-attached metal foil tape

There were prepared a solar cell (thickness: 150 $\mu$m, size: 15 cm x 15 cm) comprising a surface electrode (width: 2 mm, length: 15 cm, ten-point height of roughness profile Rz: 12 $\mu$m, maximum height Ry: 13 $\mu$m) formed from silver glass paste on the surface of a silicon wafer.

Next, the obtained adhesive-attached metal foil tape was positioned on a solar cell surface electrode and a pressure bonding tool (AC-S300 by Nikka Equipment & Engineering Co., Ltd.) was used for hot pressing at 170°C, 2 MPa, 20 seconds to accomplish bonding. This yielded a connection structure wherein the copper foil wiring member was connected to the solar cell surface electrode via the conductive adhesive film.

(Example 2)

An adhesive-attached metal foil tape was obtained in the same manner as Example 1, except for adding 2 vol% of burr-shaped Ni powder with a particle size distribution width of 1-15 $\mu$m (mean particle size: 7 $\mu$m) to the adhesive layer-forming coating solution. The adhesive-attached metal foil tape was used to obtain a connection structure in the same manner as Example 1. The added conductive particles are particles that have not been treated for uniformity of particle size, and thus have a wide particle size distribution as explained above.

(Example 3)

An adhesive-attached metal foil tape was obtained in the same manner as Example 1, except that as the metal foil there was used a 35 $\mu$m-thick rolled copper foil having projections formed on one side as shown in Table 1 (the projections having trapezoid shapes as shown in Fig. 3 and being formed in a lattice as shown in Fig. 6, with a trapezoidal projection base cross-section which was square with 1 mm sides and a tip cross-section which was square with 500 $\mu$m sides, and with a projection height (H) of 0.1 mm and an adjacent projection center point spacing (L) of 1.3 mm), and the adhesive film with an adhesive layer thickness of 15 $\mu$m was laminated on the projection-formed side of the copper foil. The adhesive-attached metal foil tape was then positioned on the surface electrode with the projection-formed side and surface electrode facing each other, and a connection structure was obtained in the same manner as Example 1.

(Example 4)

One side of a 35 $\mu$m-thick smooth rolled copper foil was directly coated with the adhesive layer-forming coating solution of Example 1 using a roll coater and dried at 110°C for 5 minutes to obtain a laminated body having an adhesive layer thickness of 15 $\mu$m.

The laminated body was wound up into a roll while taking up a polyethylene film as a separator on the adhesive layer, to obtain a wound roll. During this time, a metal roll with irregularities designed to form projections similar to Example 3 on the adhesive layer-formed side of the metal foil, by conveying under tension and embossing from the non-adhesive layer side of the metal foil, was situated on the metal foil side, and the foil was wound up while forming projections similar to Example 3 on the adhesive layer-formed side of the metal foil by rolling between rolls at room temperature. The adhesive layer also had irregularities formed following the shape of the metal foil. The wound roll was cut to a width of 2.0 mm to obtain an adhesive-attached metal foil tape. Formation of the projections was facilitated because the metal foil was a rolled copper foil. This method can help to prevent inclusion of contaminants such as dust at the interface between the metal foil and the adhesive layer.

The adhesive-attached metal foil tape was then positioned on the surface electrode with the projection-formed side and surface electrode facing each other, and a connection structure was obtained in the same manner as Example 1.

(Example 5)

An adhesive-attached metal foil tape was obtained in the same manner as Example 4, except that the projections formed on the metal foil surface had an adjacent projection center point spacing (L) of 3 mm and a projection height (H) of 1 mm. The adhesive-attached metal foil tape was used to obtain a connection structure in the same manner as Example 1.

(Example 6)

An adhesive-attached metal foil tape was obtained in the same manner as Example 4, except that the metal foil was changed to a 50 $\mu$m-thick aluminum foil. The adhesive-attached metal foil tape was used to obtain a connection structure in the same manner as Example 1. Formation of the projections was facilitated because aluminum foil is relatively soft.

(Comparative Example 1)

An adhesive-attached metal foil tape was obtained in the same manner as Example 3, except that a 35 $\mu$m-thick rolled copper foil prior to projection formation was directly used as the metal foil, and the adhesive layer was formed on one side thereof. A connection structure was obtained in the same manner as Example 3 except for using this adhesive-attached metal foil tape.

(Comparative Example 2)

An adhesive-attached metal foil tape was obtained in the same manner as Example 1, except that as the metal foil there was used a 35 $\mu$m-thick rolled copper foil having projections formed on one side as shown in Table 1 (the projections having trapezoid shapes as shown in Fig. 3 and being formed in a lattice as shown in Fig. 6, with a trapezoidal projection base cross-section which was square with 1 mm sides and a tip cross-section which was square with 350-750 $\mu$m sides, and with a projection height (H) intentionally varied within 0.07-0.15 mm and an adjacent projection center point spacing (L) of 1.3 mm), and the adhesive film with an adhesive layer thickness of 15 $\mu$m was laminated on the projection-formed side of the copper foil. The adhesive-attached metal foil tape was then positioned on the surface electrode with the projection-formed side and surface electrode facing each other, and a connection structure was obtained in the same manner as Example 1.

(Comparative Example 3)

An adhesive film was obtained using as the metal foil a 35 $\mu$m-thick rolled copper foil having projections formed on one side as shown in Table 1 (the projections having trapezoid shapes as shown in Fig. 3 and being formed in a lattice as shown in Fig. 6, with a trapezoidal projection base cross-section which was square with 1 mm sides and a tip cross-section which was square with 500 $\mu$m sides, and with a projection height (H) of 0.1 mm and an adjacent projection center point spacing (L) of 1.3 mm), and forming an adhesive layer on the projection-formed side of the copper foil with the thickness intentionally varied within 11-20 $\mu$m. An adhesive-attached metal foil tape was obtained in the same manner as Example 1, except for laminating this adhesive film. The adhesive-attached metal foil tape was then positioned on the surface electrode with the projection-formed side and surface electrode facing each other, and a connection structure was obtained in the same manner as Example 1.

<Evaluation>

The connection structures of Examples 1-6 and Comparative Examples 1-3 were evaluated based on deltaF.F., in the following manner. The results are shown in Table 1.

[deltaF.F.]

The IV curve of the obtained connection structure was measured using a solar simulator (trade name: WXS-155S-10 by Wacom Electric Co., Ltd., AM: 1.5 G). The connection structure was also allowed to stand for 1500 hours in a high-temperature, high-humidity atmosphere at 85°C, 85% RH, and the IV curve was then measured in the same manner. The F.F was derived from each IV curve, and the value of [F.F.(0 h)-F.F.(1500 h)], as the F.F. value before standing in the high-temperature, high-humidity atmosphere minus the F.F. value after standing in the high-temperature, high-humidity conditions, was recorded as Delta(F.F.) and used as the evaluation index. A Delta(F.F.) value of 0.2 or smaller is generally regarded as satisfactory connection reliability.

[Evaluation of connection structure production yield, adhesive layer moldability and metal foil tape moldability]

The connection structure production yield, adhesive layer moldability and metal foil tape moldability were evaluated for Examples 1-6. All of Examples 1-6 exhibited satisfactory connection structure production yield, adhesive layer moldability and metal foil tape moldability. Also, since the connection temperature in Examples 1-6 was a lower temperature (170°C) than the conventional soldering connection temperature (240°C), no board warping was observed. The connection structures of Examples 1-6 also had satisfactory conductivity and adhesion.

[Table 1]

| | Metal foil | | | Projections | | | | Adhesive layer | | Evaluation results |
|---|---|---|---|---|---|---|---|---|---|---|
| | Material | Thickness ($\mu$m) | Adhesive layer-formed side | Shape | Arrangement pattern | Spacing L (mm) | Height H (mm) | Conductive particles | Thickness (mm) | -Delta(F. F. ) [F.F.(1500h) -F.F.(0h)] |
| Example 1 | Cu | 75 | Both | Hemispherical | Undulated | 1.5 | 0.5 | Absent | 30 | 0.03 |
| Example 2 | Cu | 35 | Both | Hemispherical | Undulated | 1.5 | 0.5 | Present | 30 | 0.03 |
| Example 3 | Cu | 35 | One | Trapezoidal | Lattice | 1.3 | 0.1 | Absent | 15 | 0.03 |
| Example 4 | Cu | 35 | One | Trapezoidal | Lattice | 1.3 | 0.1 | Absent | 15 | 0.03 |
| Example 5 | Cu | 35 | One | Trapezoidal | Lattice | 3 | 1.0 | Absent | 30 | 0.03 |
| Example 6 | Al | 50 | One | Trapezoidal | Lattice | 3 | 1.0 | Absent | 30 | 0.03 |
| Comp. Ex. 1 | Cu | 35 | One | - | - | - | - | - | 15 | Unmeasurable |
| Comp. Ex. 2 | Cu | 35 | One | Trapezoidal | Lattice | 1.3 | 0.07-0.15 | Absent | 15 | 0.3 |
| Comp. Ex. 3 | Cu | 35 | One | Trapezoidal | Lattice | 1.3 | 0.1 | Absent | 11-20 | 0.25 |

In Comparative Example 1, the electrical connection between the electrodes and wiring member was insufficient and Delta(F.F.) was unmeasurable. In Comparative Examples 2-3, the projection heights or adhesive thicknesses were not substantially equal, and therefore the Delta(F.F.) values were large and the practical reliability was insufficient. Incidentally, there was large variation in the electrical connection in Comparative Examples 2-3 and air bubble-containing sections were found at the joints. In contrast, the Delta(F.F.) values were sufficiently small in Examples 1-6, and connection reliability was satisfactory. In addition, no air bubble-containing sections were seen at the joints in Examples 1-6.

As demonstrated by the results described above, the present invention can provide an adhesive-attached metal foil tape (member for conductor connection) which, as a substitute for solder, reduces thermal damage to solar cells and establishes electrical conduction between high-reliability solar cells by hot pressing, and a method for manufacturing it, as well as a connection structure and solar battery employing the adhesive-attached metal foil tape.

According to the adhesive-attached metal foil tape of the invention it is possible to accomplish connection between electrodes and wiring members with an adhesive and lower the connection temperature to below 200°C, while also facilitating control since warping of boards is inhibited and the tape-like form allows the adhesive layer to be formed to a constant thickness. Furthermore, since the thickness of the adhesive layer may be set in consideration of the surface condition of the adherend and only a single connection step is necessary to connect electrodes and wiring members with the adhesive, it is possible to accomplish highly efficient connection.

**Industrial Applicability**

As explained above, it is possible according to the invention to provide a member for conductor connection that can simplify the connection steps for electrical connection between mutually separate conductors while also exhibiting excellent connection reliability, as well as a method for manufacturing the same. According to the invention it is also possible to provide a connection structure and solar cell module whereby excellent productivity and high connection reliability can both be achieved.

**Claims**

1. A member for conductor connection having an adhesive layer formed on at least one side of a metal foil,
   wherein the metal foil comprises a plurality of projections of substantially equal height integrated with the metal foil, on the side on which the adhesive layer is formed, and
   the adhesive layer is formed to a substantially uniform thickness along the projections.

2. A member for conductor connection according to claim 1, which permits electrical conduction between the metal foil and conductor when the member for conductor connection is connected to the conductor by hot pressing.

3. A member for conductor connection according to claim 1 or 2,
   wherein the projections have shapes with smaller cross-sectional areas at the tips than the cross-sectional areas at the bases, and are regularly arranged with a center point spacing L between adjacent projection tips in the range of 0.1-5 mm, and the heights H of the projections are less than the center point spacing L.

4. A member for conductor connection according to any one of claims 1 to 3, wherein the metal foil is one comprising at least one metal selected from the group consisting of among Cu, Ag, Au, Fe, Ni, Pb, Zn, Co, Ti, Mg, Sn and Al.

5. A member for conductor connection according to any one of claims 1 to 4, wherein the adhesive layer is a layer comprising a thermosetting adhesive composition that contains a latent curing agent.

6. A member for conductor connection according to any one of claims 1 to 5, wherein the adhesive layer is a layer comprising an adhesive composition that contains conductive particles, the mean particle size of the conductive particles being no greater than the heights H of the projections of the metal foil.

7. A method for manufacturing a member for conductor connection according to any one of claims 1 to 6, the method comprising
   a step of forming the projections on at least one side of the metal foil, and then laminating an adhesive film on the side of the metal foil on which the projections have been formed to form an adhesive layer.

8. A method for manufacturing a member for conductor connection according to any one of claims 1 to 6, the method comprising

a step of forming the adhesive layer on at least one side of the metal foil, and then embossing the metal foil to form projections on the side of the metal foil on which the adhesive layer has been formed.

9. A connection structure comprising a metal foil and a conductor that are electrically connected and bonded, the connection structure being obtained by situating a member for conductor connection according to any one of claims 1 to 6 and a conductor so that the side of the metal foil of the member for conductor connection on which the projections have been formed and the conductor are facing each other via an adhesive layer, and hot pressing them.

10. A connection structure according to claim 9, wherein the surface of the conductor connected to the metal foil has surface roughness, and the projections on the surface roughness sections of the conductor are in contact with the projections of the metal foil.

11. A connection structure according to claim 9 or 10, wherein
the adhesive layer comprises conductive particles, and
the conductor and metal foil are electrically connected via the conductive particles.

12. A solar cell module comprising a plurality of solar cells with surface electrodes, wherein
each of the solar cells is electrically connected to the surface electrode via a metal foil bonded with a bonding member,
the metal foil is formed of a member for conductor connection according to any one of claims 1 to 6, and
the side of the metal foil in contact with the surface electrode is the side on which the projections have been formed.

13. A solar cell module according to claim 12, wherein
the bonding member comprises conductive particles, and
the surface electrode and metal foil are electrically connected via the conductive particles.

14. A solar cell module according to claim 12 or 13, wherein the surface of the surface electrode on which the metal foil has surface roughness,
the projections on the surface roughness sections of the surface electrode are in contact with the projections of the metal foil to form electrically connected sections, and
the sections of the metal foil other than those at the electrically connected sections are essentially covered by the bonding member.

*Fig.1*

Fig.2

*Fig.3*

# Fig.4

# Fig.5

(a)

(b)

(c)

## Fig.6

(a)

(b)

(c)

# Fig.7

(a)

(b)

(c)

*Fig.8*

*Fig.9*

*Fig.10*

*Fig.11*

EP 2 200 093 A1

Fig.12

## INTERNATIONAL SEARCH REPORT

| International application No. |
| --- |
| PCT/JP2008/067305 |

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/04-31/078, C09J7/00-7/04

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho    1971-2008   Toroku Jitsuyo Shinan Koho    1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2002-97424 A  (3M Innovative Properties<br>Co.),<br>02 April, 2002 (02.04.02),<br>Par. Nos. [0005], [0012], [0024], [0026],<br>[0032], [0057], [0067], [0068], [0090]; Fig. 1<br>& EP 1315780 A        & WO 2002/020686 A2<br>& AU 8892501 A         & CN 1639290 A | 1-11<br>12-14 |
| Y | JP 7-147424 A  (Fuji Electric Co., Ltd.),<br>06 June, 1995 (06.06.95),<br>Par. Nos. [0008], [0010]; Fig. 3<br>(Family: none) | 1-14 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    09 October, 2008 (09.10.08) | Date of mailing of the international search report<br>    21 October, 2008 (21.10.08) |
| --- | --- |
| Name and mailing address of the ISA/<br>    Japanese Patent Office | Authorized officer |
| Facsimile No. | Telephone No. |

Form PCT/ISA/210 (second sheet) (April 2007)

**INTERNATIONAL SEARCH REPORT**

| International application No. |
|---|
| PCT/JP2008/067305 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2004-23853 A  (Sumitomo Wiring Systems, Ltd.), 22 January, 2004 (22.01.04), Fig. 4 (Family: none) | 1-14 |
| A | JP 54-78735 A  (Fujikura Densen Kabushiki Kaisha), 23 June, 1979 (23.06.79), Page 2; Fig. 2 (Family: none) | 1-14 |
| A | JP 10-326904 A  (Fuji Electric Co., Ltd.), 08 December, 1998 (08.12.98), Par. No. [0012] (Family: none) | 12-14 |
| A | JP 3-6867 A  (Mitsubishi Electric Corp.), 14 January, 1991 (14.01.91), Figs. 5 to 6 & US 5084107 A           & US 5151373 A & FR 2647960 A | 12-14 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 20042FLU256 B
- JP 2000286436 A
- JP 2005101519 A